# EUROPÄISCHE PATENTANMELDUNG

(11) **EP 1 304 800 A1**
(43) Veröffentlichungstag der Anmeldung: **23.04.2003**
(21) Anmeldenummer: 01440350.5
(22) Anmeldetag: 22.10.2001
(51) Int. Cl.: H03K 3/023, H03B 5/00

(54) **Vorrichtung zur Generierung eines modulierten HF-Magnetfeldes**

(71) Anmelder: ALCATEL, 75008 Paris (FR)
(72) Erfinder: Altermann, Robert, 2020 Hollabrunn (AT)
(74) Vertreter: Menzietti, Domenico, Dipl.-Ing

(57) **Zusammenfassung**

Aufgabe der Erfindung ist es, ein moduliertes hochfrequentes magnetisches Feld mittels elektrischer Spule zu erzeugen, wobei die notwendige elektrische Leistung und die notwendige elektrische Spannung minimiert werden sollen. Erfindungsgemäß wird für die Magnetfelderzeugung eine elektrische Spule (L) verwendet, die mit einem Kondensator (C) zu einem seriellen Schwingkreis zusammengeschaltet ist. Der Schwingkreis ist mit einem Leistungsverstärker (D, M, I) betrieben, wobei der wegen der geforderten Modulation des Stromes notwendige Dämpfungswiderstand nicht reell vorhanden ist, sondern nur virtuell mittels Regelung nachgebildet ist. Der Wert des virtuellen Widerstands lässt sich vorteilhafterweise durch eine Spannung (Uᵥ) steuern, so dass sich die Schwingkreisdynamik während des Betriebs adaptieren lässt.

## Beschreibung

Die Erfindung betrifft eine Vorrichtung zur Generierung eines modulierten HF-Magnetfeldes.

Im NF-Bereich wird zur Erzeugung eines Magnetfeldes eine Spule verwendet. Im HF-Bereich wird dazu ein gedämpfter elektrischer Schwingkreis mit reellem, ohmschen Widerstand verwendet. Es besteht die Notwendigkeit einer hohen Spannung an der Spule für das Treiben des Stromes.

Aufgabe der Erfindung ist es, ein moduliertes hochfrequentes magnetisches Feld mittels elektrischer Spule zu erzeugen, wobei die notwendige elektrische Leistung und die notwendige elektrische Spannung minimiert werden sollen.

Gelöst wird diese Aufgabe durch eine erfindungsgemäße Vorrichtung gemäß Patentanspruch 1.

Für die Magnetfelderzeugung wird eine elektrische Spule verwendet, die mit einem Kondensator zu einem seriellen Schwingkreis zusammengeschaltet ist. Der Schwingkreis ist mit einem Leistungsverstärker betrieben, wobei der wegen der geforderten Modulation des Stromes notwendige Dämpfungswiderstand nicht reell vorhanden ist, sondern nur virtuell mittels Regelung nachgebildet ist. Der Wert des virtuellen Widerstands lässt sich vorteilhafterweise durch eine Spannung steuern, so dass sich die Schwingkreisdynamik während des Betriebs adaptieren lässt.

Durch die erfindungsgemäße Vorrichtung werden elektrische Verluste an einem reellen Dämpfungswiderstand vermieden. Dies kommt besonders zum Tragen, wenn der Wert des Dämpfungswiderstandes bei einer hohen Modulationsfrequenz sehr groß sein muss.

Ferner wird die Spannung zum Betreiben des gedämpften Schwingkreises reduziert. Damit können kostengünstige Standard-Leistungshalbleiter verwendet werden.

Des weiteren werden die Verluste im Leistungsverstärker reduziert, da der notwendige Spannungsbereich zum Betreiben des Schwingkreises reduziert ist. Da der Leistungsteil nahe dem Vollaussteuerbereich betrieben werden kann, erfolgt der Betrieb nahe dem theoretischen Wirkungsmaximum.

Vorteilhaft wirkt sich ferner aus, dass die Blindleistung reduziert ist.

Die Möglichkeit der Adaption des fiktiven Widerstandes lässt beispielsweise folgende Anwendungen zu: Dynamische Adaption des Frequenzganges des Schwingkreises (Bandbreite) und/oder Ausgleich von Bauteiltoleranzen des verwendeten Kondensators infolge Bauteilalterung mittels überlagerter Regelung.

Vorteilhafte Ausgestaltungen der Erfindung sind den abhängigen Ansprüchen und der nachfolgenden Beschreibung zu entnehmen.

Im folgenden wird ein Ausführungsbeispiel der Erfindung anhand von vier Figuren erläutert. Es zeigen:
- Fig. 1: eine schematische Darstellung einer erfindungsgemäßen Vorrichtung,
- Fig. 2: ein Diagramm zum Verlauf der Ausgangsspannung über die Zeit,
- Fig. 3: ein Diagramm zum Verlauf des Ausgangsstromes über die Zeit,
- Fig. 4: ein Diagramm zum Verlauf der Eingangsspannung über die Zeit.

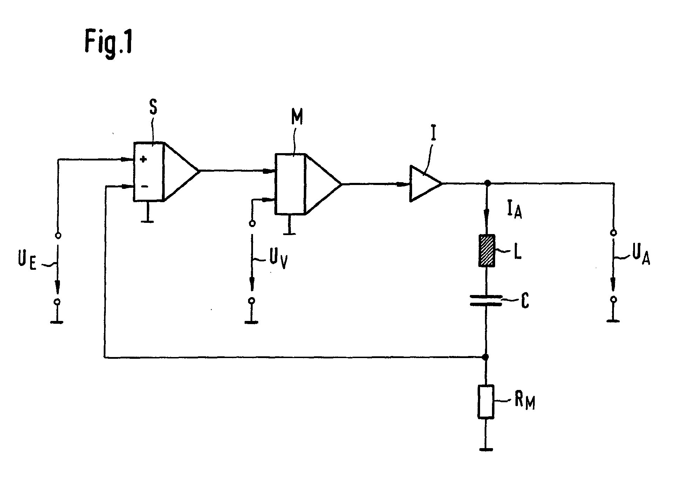

Das Ausführungsbeispiel wird zunächst anhand von Fig. 1 erläutert. Fig. 1 zeigt eine schematische Darstellung einer erfindungsgemäßen Vorrichtung.

Die Vorrichtung beinhaltet einen Subtrahierer S, einen Multiplizierer M, einen Impedanzwandler I, eine Spule L, einen Kondensator C und einen ohmschen Messwiderstand R_{M}.

Der Subtrahierer S hat einen positiven und einen negativen Eingang und einen Ausgang. Am positiven Eingang liegt die Eingangsspannung U_{E} an. Der Multiplizierer M hat einen ersten und einen zweiten Eingang und einen Ausgang. Der erste Eingang ist mit dem Ausgang des Subtrahierers S verbunden. Am zweiten Eingang liegt die Verstärkungsspannung U_{V} an. Der Multiplizierer M ist beispielsweise als elektronischer 2-Quadranten-Analogmultiplizierer nach dem Prinzip des Steilheitsmultiplizierers ausgeführt.
Der Impedanzwandler I hat einen Eingang und einen Ausgang. Der Eingang ist mit dem Ausgang des Multiplizierers M verbunden. Am Ausgang liegt die Ausgangsspannung U_{A} an. Der Ausgang ist ferner über die Reihenschaltung aus Spule L und Kondensator C auf den negativen Eingang des Subtrahierers S zurückgekoppelt.
Der lmpedanzwandler I ist beispielsweise als elektronischer HF-Leistungsverstärker mit dem Verstärkungsfaktor 1 (entspricht einem echten lmpedanzwandler) ausgeführt.

Messwiderstand R_{M} ist zum einen an Masse und zum anderen zwischen Kondensator C und negativem Eingang des Subtrahierers S angeschlossen.

Durch die Spule L fließt der Ausgangsstrom I_{A}.

Der LC-Schwingkreis der Vorrichtung wird mit dem lmpedanzwandlers I angesteuert, der infolge des Zusammenwirkens mit dem Subtrahierer, dem Multiplizierer M und dem Meßwiderstandes R_{M} einen definierten positiven linearen Ausgangswiderstand besitzt (zwischen dem Ausgang des Impedanzwandlers und dem Meßwiderstand). Dieser Ausgangswiderstand ergibt sich rein rechnerisch und hat keinen reell existierenden Widerstand zur Grundlage. Bei Erhöhung des Ausgangsstromes I_{A} tritt eine Verminderung des Ausgangsspannung U_{A} ein. Der Ausgangsstrom I_{A} wird über den Messwiderstand R_{M} gemessen. Die am Messwiderstand R_{M} abfallende Spannung wird rückgekoppelt an den negativen Eingang des Subtrahierers S.

Der Multipizierer M soll einen Ausgangsspannungsbegrenzer aufweisen.

In der praktischen Umsetzung dieses Prinzipes können die drei Komponenten, Impedanzwandler, Subtrahierer und Multiplizierer, in einer Komponente zusammengefaßt sein: Dann liegt ein HF-Leistungsdifferenzverstärker vor mit einstellbarem Verstärkungsfaktor und einer Ausgangsspannungsbegrenzung.

Im folgenden wird ein Beispiel einer Dimensionierung der Bauteile angegeben:

Es wird von folgenden Annahmen ausgegangen: Das Magnetfeld soll durch eine Spule von 1 Mikrohenry (1 µH) erzeugt werden. Ein modulierter Strom mit der Spitzenstromstärke von 1 Ampère (1 A) soll ausreichend sein für das benötigte magnetische Feld. Es soll eine Amplitudenmodulation mit einem Modulationsgrad von 50% verwendet werden. Die Trägerfrequenz sei 15,95 MHz. Das aufmodulierte Signal soll eine Bandbreite von 0 bis 1,59 MHz besitzen.

Die Kapazität des Kondensators C des auf 15,95 MHz abgestimmten Schwingkreises bestimmt sich nach der Thomsonformel zu 100 Pikofarad (100 pF).

Zur Dimensionierung des virtuellen Widerstandes R des LCR-Schwingkreises:
Damit beim Einschwingvorgang des Schwingkreises der sogenannte Schwingungsfall vorliegt, muss gelten RxR < 4xL/C. Damit bestimmt sich der Wert des Widerstandes R zu R < 632,4 Ohm.
Die Zeitkonstante des Schwingkreises soll ein Drittel der minimalen Modulationsperiode T betragen, damit der Einschwingvorgang rasch genug beendet ist. Dazu muss der Wert des Widerstandes R größer oder gleich 3x2xL/T sein. Für das vorliegende Beispiel wird ein Wert R = 95,2 Ohm gewählt.

Zur Dimensionierung des Verstärkungsfaktors V, der über die Verstärkungsspannung U_{V} nachgeregelt wird:
Mit einem Messwiderstand R_{M} von 1 Ohm wird der Ausgangsstrom I_{A} gemessen. Der Verstärkungsfaktor V bestimmt sich zu V=R/R_{M}-1. Damit ergibt sich V=94,2. Am zweiten Eingang ist eine Verstärkungsspannung U_{V}=9,42 Volt anzulegen bei einer Verstärkung des Multiplizierers M von zehn.

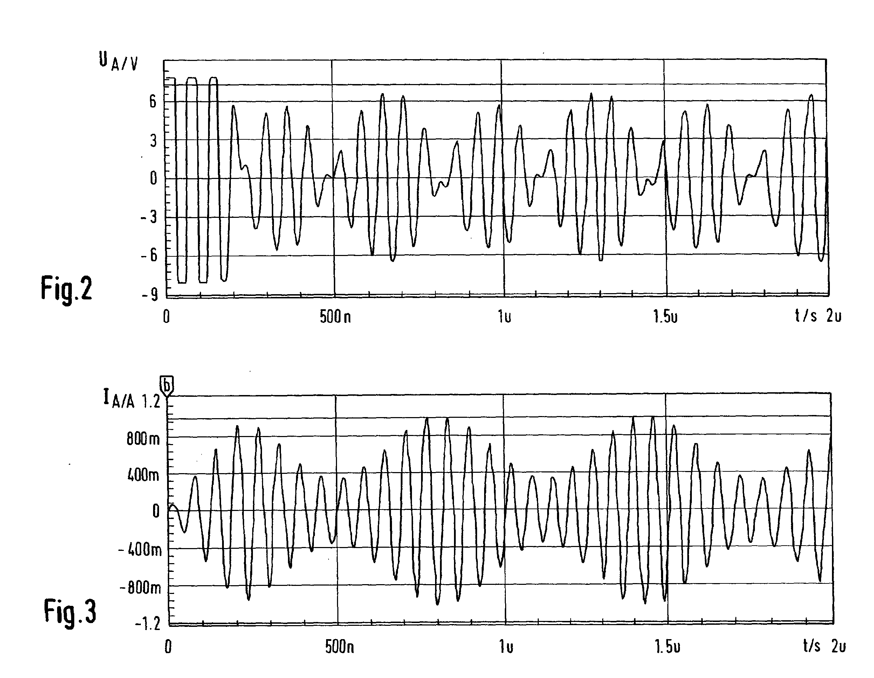

Mit obigen Werten schwingt sich das System nach ca. 500ns ein, siehe Fig. 2 bis 4, und der Spitzenwert des modulierten Ausgangstromes I_{A} beträgt ca. 1 A. Die notwendige maximale Ausgangsspannung U_{A} des Leistungsverstärkers beträgt nur ca. 7 Volt. Während des Systemeinschwingvorganges reichen ca. 8 Volt aus. Der erfindungsgemäße Leistungsverstärker wird gebildet durch den Subtrahierer S, den Multiplizierer M und den Impedanzwandler I. Die Ausgangsspannung U_{A} des Leistungsverstärkers kann mit 8 Volt limitiert werden. Die Spannung an der Spule L beträgt ca. 100 Volt.

Fig. 2 zeigt ein Diagramm zum Verlauf der Ausgangsspannung U_{A} über die Zeit mit der Y-Achse in Volt und der X-Achse in Sekunden. Während der ersten ca. 200 ns ist die Spannungsbegrenzung der Ausgangsspannung U_{A} erkennbar.

Fig. 3 zeigt ein Diagramm zum Verlauf des Ausgangsstromes I_{A} über die Zeit mit der Y-Achse in Ampère und der X-Achse in Sekunden.

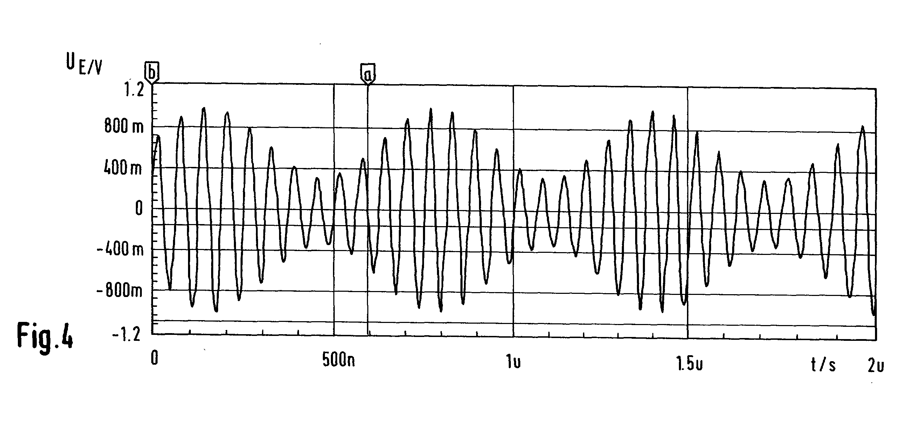

Fig. 4 zeigt ein Diagramm zum Verlauf der Eingangsspannung U_{E} über die Zeit mit der Y-Achse in Volt und der X-Achse in Sekunden. Die Eingangsspannung U_{E} und der Ausgangsstrom I_{A} sind praktisch in Phase.

Die erfindungsgemäße Vorrichtung kann als Sender für alle Datenübertragungsprodukte verwendet werden, die auf induktiver Übertragung beruhen, z.B. Informationsübertragung unter schwierigen EMV-Bedingungen zwischen Lokomotive und Balisen im Rahmen des ETCS-Konzeptes

Bezüglich Dimensionierung ist folgendes festzuhalten:
Aus den dynamischen Anforderungen ergibt sich der notwendige minimale virtuelle Widerstand R. Aus diesem folgt der Verstärkungsfaktor V.
Die theoretische Leerlaufspannung auf Ausgang des Impedanzwandlers (im Fall des Ausgangsstromes 0) beträgt: U_{E} x V. Diese Leerlaufspannung kann natürlich infolge der Spannungsbegrenzung nicht erreicht werden.
Die Ausgangsspanngsbegrenzung ist so zu wählen, dass der Wert dieser Spannung geringfügig größer ist als der Wert der Ausgangsspannung, der für das Treiben des gewünschten Stromes durch die Spule notwendig ist. Für den Wert der notwendigen theoretischen Leerlaufspannung sei auf die Dimensionierung eines gedämpften, seriellen Schwingkreises verwiesen, wobei der Widerstand des Schwingkreises hier dem obigen virtuellen Widerstand R entspricht.

## Patentansprüche

1. Vorrichtung zur Generierung eines modulierten HF-Magnetfeldes, **dadurch gekennzeichnet, dass** eine Reihenschaltung aus einem Subtrahierer (S) einem Impedanzwandler (I), einer Spule (L), einem Kondensator (C) und einem Messwiderstand (RM) vorhanden ist, wobei die Spannung über dem Messwiderstand (RM) als negative Eingangspannung des Subtrahierers (S) dient.

2. Vorrichtung nach Anspruch 1, **dadurch gekennzeichnet, dass** zwischen Subtrahierer (S) und lmpedanzwandler (I) ein Multiplizierer (M) geschaltet ist, dessen zweite Eingangsspannung regelbar ist und zur Adaption eines virtuellen Widerstandes dient.

3. Vorrichtung nach Anspruch 1, **dadurch gekennzeichnet, dass** die Eingangsspannung der Vorrichtung als positive Eingangsspannung des Subtrahierers (S) dient, und dass am Ausgang des Impedanzwandlers (I) die Ausgangsspannung der Vorrichtung vorliegt.

4. Vorrichtung zur Generierung eines modulierten HF-Magnetfeldes, **dadurch gekennzeichnet, dass** eine Reihenschaltung aus einem HF-Leistungsdifferenzverstärker (S, I, M), einer Spule (L), einem Kondensator (C) und einem Messwiderstand (RM) vorhanden ist, wobei die Spannung über dem Messwiderstand (RM) als negative Eingangspannung des HF-Leistungsdifferenzverstärkers (S, I, M) dient.

5. Vorrichtung nach Anspruch 4, **dadurch gekennzeichnet, dass** der HF-Leistungsdifferenzverstärker (S, I, M) einen einstellbaren Verstärkungsfaktor und eine Ausgangsspannungsbegrenzung aufweist.
